# EUROPEAN PATENT APPLICATION

(11) **EP 2 503 620 A1**
(43) Date of publication of application: **26.09.2012**
(21) Application number: 11180869.7
(22) Date of filing: 12.09.2011
(51) Int. Cl.: H01L 51/52, H05B 33/10, H05B 33/12, H05B 33/22, H05B 33/28

(54) **Organic electroluminescent device, display device, and illumination device**

(30) Priority: 24.03.2011 JP 2011066662
(71) Applicant: Kabushiki Kaisha Toshiba, Tokyo 105-8001 (JP)
(72) Inventor: Kato, Daimotsu, Tokyo 105-8001 (JP); Sugi, Keiji, Tokyo 105-8001 (JP); Yonehara, Toshiya, Tokyo 105-8001 (JP); Sawabe, Tomoaki, Tokyo 105-8001 (JP); Ono, Tomio, Tokyo 105-8001 (JP); Enomoto, Shintaro, Tokyo 105-8001 (JP)
(74) Representative: HOFFMANN EITLE

(57) **Abstract**

According to one embodiment, an organic electroluminescent device comprises a translucent substrate, a light extraction layer including a convex structure disposed in a net form on one surface of the substrate and having a tilted surface forming an acute angle relative to the substrate, and a planarizing layer disposed on the convex structure, a first electrode disposed on the light extraction layer, a luminescent layer disposed on the first electrode and containing a host material and a luminescent dopant, and a second electrode disposed on the luminescent layer. A refractive index of the planarizing layer is approximately equal to a refractive index of the first electrode or is larger than the refractive index of the first electrode, and a refractive index of the convex structure is smaller than a refractive index of the planarizing layer.

## Description

### CROSS REFERENCE TO RELATED APPLICATIONS

This application is based upon and claims benefit of priority from the Japanese Patent Application No. 2011-66662, filed on March 24, 2011, the entire contents of which are incorporated herein by reference.

### FIELD

Embodiments described herein relate generally to an organic electroluminescent device, a display device, and an illumination device.

### BACKGROUND

In recent years, organic electroluminescent devices (hereafter also referred to as organic EL devices) are attracting people's attention for use such as a plane light source. An organic electroluminescent device has such a construction that a luminescent layer made of an organic material is sandwiched between a pair of electrodes made of a negative electrode and a positive electrode. When a voltage is applied to the device, electrons are injected into the luminescent layer from the negative electrode, and positive holes are injected into the luminescent layer from the positive electrode, whereby the electrons and the positive holes are recombined in the luminescent layer to generate an exciton, and luminescence is obtained when this exciton undergoes radiative deactivation.

However, since adjacent layers such as the positive electrode and the substrate or the substrate and the air layer are different in refractive index, light is reflected at the interface thereof, raising a problem in that the light generated in the luminescent layer cannot be taken out efficiently to the outside. In a typical organic electroluminescent device, the ratio of the light that can be taken out to the outside of the device among the light generated within the luminescent layer is about 20%; the ratio of the light that cannot be taken out from the substrate though reaching the substrate is about 30%; and the ratio of the light that cannot reach the substrate and is confined into the luminescent layer or the electrodes is about 50%.

In order to improve the luminescence efficiency of an organic EL device, various attempts are devised so as to extraction the light confined in the luminescent layer or the electrodes efficiently to the outside.

### BRIEF DESCRIPTION OF THE DRAWINGS

Fig. 1 is a cross-sectional view illustrating an organic electroluminescent device according to a first embodiment;
Fig. 2 is a plan view illustrating a convex structure in the organic electroluminescent device according to the first embodiment;
Fig. 3 is a plan view illustrating a convex structure in the organic electroluminescent device according to the first embodiment;
Fig. 4 is an enlarged cross-sectional view illustrating a part of the convex structure in Fig. 1;
Fig. 5 is a cross-sectional view illustrating one mode of the organic electroluminescent device according to the first embodiment;
Fig. 6 is a plan view illustrating a convex structure in the organic electroluminescent device according to a second embodiment;
Figs. 7A-7C are cross-sectional views illustrating an organic electroluminescent device according to a third embodiment;
Figs. 8A-8C are cross-sectional views illustrating a modification of the organic electroluminescent device according to the third embodiment;
Fig. 9 is a circuit diagram illustrating a display device according to an embodiment;
Fig. 10 is a cross-sectional view illustrating an illumination device according to an embodiment;
Fig. 11 is a photograph view illustrating an SEM image of the convex structure in the organic EL device according to Example 1-1;
Fig. 12 is an enlarged cross-sectional view along the line X-X of the convex structure shown in Fig. 11;
Fig. 13 is a photograph view illustrating an SEM image of the convex structure in the organic EL device according to Example 2-1;
Fig. 14 is a photograph view illustrating an SEM image of the convex structure in the organic EL device according to Example 3-1;
Fig. 15 is a photograph view illustrating an SEM image of the convex structure in the organic EL device according to Example 4-1;
Fig, 16 is a view showing an external quantum efficiency of the organic EL devices according to Example 1-2, Comparative Example 1, and Comparative Example 2;
Fig. 17 is a view showing an external quantum efficiency of the organic EL devices according to Example 1-2, Comparative Example 1, and Comparative Example 2;
Fig. 18 is a view showing an external quantum efficiency of the organic EL devices according to Example 3-2, Comparative Example 1, and Comparative Example 2;
Fig. 19 is a view showing an external quantum efficiency of the organic EL devices according to Example 4-2, Comparative Example 1, and Comparative Example 2; and
Fig. 20 is a view showing a simulation result in Test Example 3.

### DETAILED DESCRIPTION

According to one embodiment, an organic electroluminescent device comprises a translucent substrate, a light extraction layer including a convex structure disposed in a net form on one surface of the substrate and having a tilted surface forming an acute angle relative to the substrate, and a planarizing layer disposed on the convex structure, a first electrode disposed on the light extraction layer, a luminescent layer disposed on the first electrode and containing a host material and a luminescent dopant, and a second electrode disposed on the luminescent layer. A refractive index of the planarizing layer is approximately equal to a refractive index of the first electrode or is larger than the refractive index of the first electrode, and a refractive index of the convex structure is smaller than a refractive index of the planarizing layer.

Hereafter, embodiments of the present invention will be described with reference to the attached drawings.

### (First embodiment)

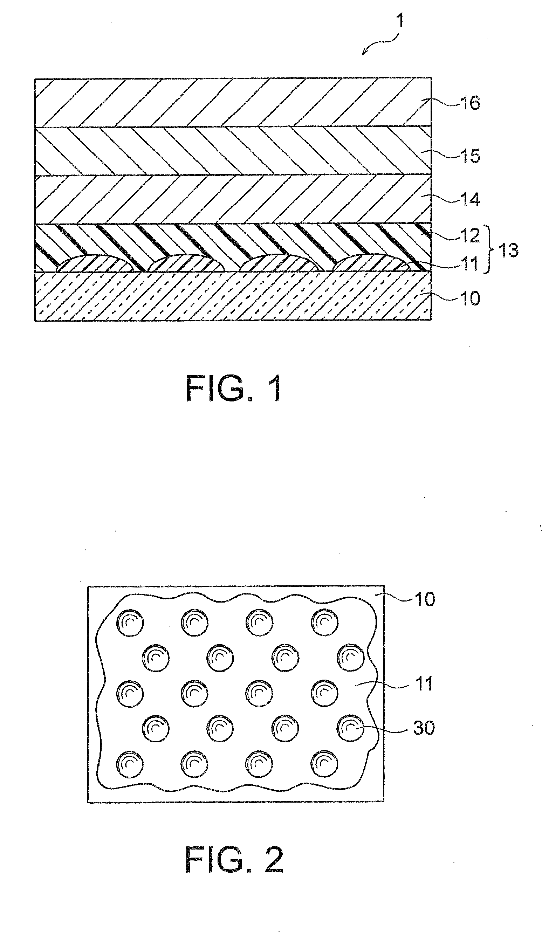

Fig. 1 is a cross-sectional view illustrating an organic electroluminescent device according to a first embodiment.

An organic electroluminescent device 1 has a structure such that a light extraction layer 13, a first electrode 14, a luminescent layer 15, and a second electrode 16 are successively formed on a substrate 10. The light extraction layer 13 includes a convex structure 11 disposed on one surface of the substrate 10 and a planarizing layer 12 disposed on the convex structure 11.

Referring to Fig. 1, by providing the planarizing layer 12 having a refractive index equivalent to or larger than that of the first electrode 14 between the first electrode 14 and the substrate 10, the probability that the light generated in the luminescent layer 15 undergoes total reflection at the interface between the first electrode 14 and the planarizing layer 12 will be lower. Therefore, the ratio of the light that proceeds to the planarizing layer 12 side without being reflected at the interface between the first electrode 14 and the planarizing layer 12 will increase. The light that has propagated from the first electrode 14 into the planarizing layer 12 proceeds towards the interface between the planarizing layer 12 and the substrate 10. Here, by providing the convex structure 11 on the substrate 10, the probability of total reflection of the light at the interface between the planarizing layer 12 and the substrate 10 can be lowered. Also, by making the refractive index of the convex structure 11 be smaller than the refractive index of the planarizing layer 12, the probability that the light that has reached the surface of the convex structure 11 is refracted to the substrate 10 side can be enhanced.

The light extraction layer 13 is a layer for efficiently taking out the light from the first electrode 14 to the substrate 10 side and includes the convex structure 11 disposed on the substrate 10 and the planarizing layer 12 disposed on the convex structure 11.

The planarizing layer 12 is a member for obtaining a planarized surface by filling the unevennesses formed by the convex structure 11 so as to laminate the first electrode 14, the second electrode 16, and the luminescent layer 15 thereon. By providing the planarizing layer 12 having a flat top surface on the convex structure 11, the thickness in the plane direction of the first electrode 14, the second electrode 16, and the luminescent layer 15 formed thereon can be made uniform. When the thickness of the luminescent layer 15 is uneven instead of being uniform, a brightness irregularity is liable to be generated in the device. Therefore, the first electrode 14, the second electrode 16, and the luminescent layer 15 are preferably formed on a flat surface. Further, the planarizing layer 12 also serves to adjust the distance between the first electrode 14 and the substrate 10 to be a distance suitable for efficiently taking the light out.

The refractive index of the planarizing layer 12 may be approximately equal to or larger than the refractive index of the first electrode 14. In order to extract the light more efficiently from the first electrode 14 to the planarizing layer 12, the planarizing layer 12 preferably has a refractive index approximately equal to that of the first electrode 14. In other words, the refractive indices of the first electrode 14 and the planarizing layer 12 are preferably within a range of about ±0.3, and are more preferably equal to each other. When the refractive index of the planarizing layer 12 is smaller by a certain degree than the refractive index of the first electrode 14, the light from the first electrode 14 may undergo total reflection at the interface between the first electrode 14 and the planarizing layer 12, or may have a high probability of being refracted in a direction away from the substrate, whereby the light extraction efficiency to the substrate side will be poor. In contrast, by setting the refractive indices of the first electrode 14 and the planarizing layer 12 to be of the same degree, there will be a high possibility that the light from the first electrode 14 may pass straightly through the interface between the first electrode 14 and the planarizing layer 12. Also, by setting the refractive index of the planarizing layer 12 to be larger than the refractive index of the first electrode 14, the light can be refracted to the substrate 10 side. As a result of these, the light extraction efficiency to the substrate side can be improved.

The convex structure 11 is a member for preventing the light that enters the planarizing layer 12 from the first electrode 14 from undergoing total reflection at the interface between the planarizing layer 12 and the substrate 10 and for allowing the light that has reached the convex structure 11 surface to be refracted to the substrate side. In the first embodiment, the convex structure 11 is disposed in a net form on the substrate 10.

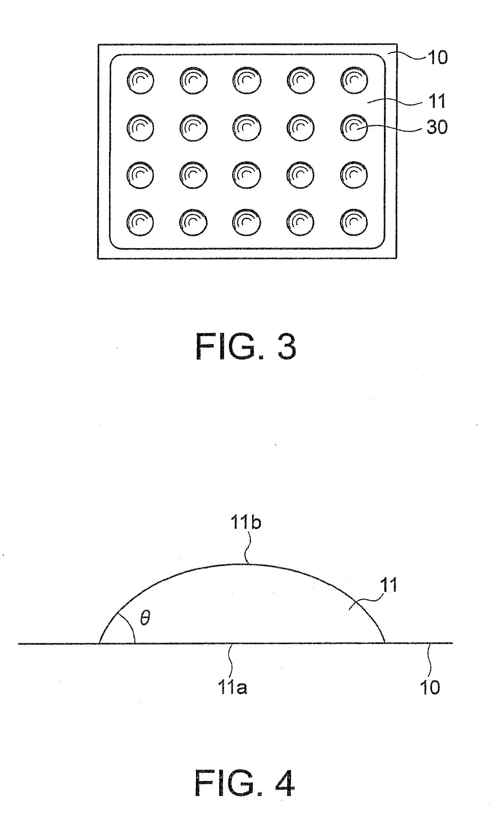

Figs. 2 and 3 are plan views illustrating the convex structure 11 in the first embodiment. In Figs. 2 and 3, the convex structure 11 is disposed in a lattice form on the substrate 10, where, in particular, the convex structure 11 is disposed in a triangular lattice form in Fig. 2 and is disposed in a square lattice form in Fig. 3. The shape of the convex structure 11 need not be a lattice form and may have a net structure in which the concave portions 30 are formed at random positions. The concave portions 30 may have a shape such that, by the recesses thereof, the convex structure 11 will have a net structure, so that the shape thereof is not limited to a hemispherical shape. The bottom surface of the concave portions 30 may reach the substrate 10 or may not reach the substrate 10, and also the shape of the bottom surface is not particularly limited.

The convex structure 11 is formed on the substrate 10 so as to have a tilted surface that forms an acute angle relative to the substrate 10. The fact that the tilted surface forms an acute angle relative to the substrate 10 means that, for example, as shown in Fig. 4, the angle θ that the tilted surface at fringe portions of the convex structure 11 forms relative to the substrate 10 is an acute angle. The shape of the convex structure 11 may be such that the tilted surface that forms an acute angle relative to the substrate 10 is within a part of the surface of the convex structure 11 that is in contact with the planarizing layer 12, so that the shape is not limited to the one shown in Fig. 4. When the convex structure 11 has a tilted surface that forms an acute angle relative to the substrate 10, the probability that the light that has reached the surface of the convex structure 11 undergoes total reflection at the surface thereof will be low, and the probability that the light is refracted to the substrate 10 side can be enhanced.

The shape of the convex structure 11 disposed in a net form as viewed in a cross-section perpendicular to the longitudinal direction is not particularly limited, however, the shape may be, for example, a hemisphere, a triangle, or the like. As shown in Fig. 4, it is particularly preferable that a bottom surface 11a is in contact with the substrate 10, and a surface 11b that is in contact with the planarizing layer has an arch shape.

When the top surface of the convex structure 11 is a surface parallel to the substrate 10, the light that has reached the surface of the convex structure 11 cannot be refracted to the substrate 10 side. In contrast, by forming the top surface 11b of the convex structure 11 to have an arch shape, the probability that the light that has reached the surface of the convex structure 11 is refracted to the substrate 10 side can be enhanced.

In order to refract the light that has reached the surface of the convex structure 11 efficiently to the substrate 10 side, the refractive index of the convex structure 11 is set to be smaller than the refractive index of the planarizing layer 12. Even when the refractive indices are made to have such a relationship, there exists light that is reflected at the surface of the convex structure 11 depending on the direction of incidence of the light. However, part of the reflected light repeats being reflected and returns to the surface of the convex structure 11 again. Therefore, by allowing the returning light to be eventually refracted to the substrate 10 side, even the light such as this can be extracted to the substrate 10 side.

The convex structure 11 preferably has a refractive index of the same degree as or smaller than that of the substrate 10. In order to take the light out efficiently from the convex structure 11 to the substrate 10, the refractive index of the convex structure 11 is preferably approximately equal to the refractive index of the substrate 10. In other words, the difference between the refractive index of the convex structure 11 and the refractive index of the substrate 10 is preferably within a range of about ±0.2, and are more preferably equal to each other. When the refractive index of the convex structure 11 is larger by a certain degree than the refractive index of the substrate 10, the light from the convex structure 11 may undergo total reflection at the interface between the convex structure 11 and the substrate 10, or may have a high probability of being refracted in a direction away from the substrate, whereby the light extraction efficiency to the substrate side will be poor. In contrast, by setting the refractive indices of the convex structure 11 and the substrate 10 to be of the same degree, the light from the convex structure 11 passes straightly through the interface between the convex structure 11 and the substrate 10 without being refracted. Also, by setting the refractive index of the convex structure 11 to be smaller than the refractive index of the substrate 10, the light can be efficiently refracted to the substrate 10 side. As a result of these, the light extraction efficiency to the substrate 10 side can be improved.

The material of the convex structure 11 is not particularly limited as long as it is a translucent material. For example, a transparent resin material such as polyester, polyimide, or epoxy can be used. The convex structure 11 can be provided on the substrate 10 by forming a desired uneven pattern using a pattern forming technique such as photolithography after forming a film of a resin material such as mentioned above on the substrate 10. A method of forming the film of the resin material may be, for example, the application method by which the film can be formed by heating and solidifying after coating the substrate 10 surface with the material.

The material of the planarizing layer 12 is not particularly limited as long as it is a material that is translucent and enables obtaining a substantially flat surface. Specifically, for example, a transparent resin material such as polyester, polyimide, or epoxy can be used; however, a material different from the convex structure 11 is used. A method of forming a film of the planarizing layer 12 may be, for example, the application method by which the film can be formed by heating and solidifying after the substrate 10 surface on which the convex structure 11 has been formed is coated with the material.

In a conventional structure, there is a high probability that the light undergoes total reflection at the interface between the first electrode and the substrate, raising a problem in that the light cannot be efficiently taken out to the substrate side. However, by providing the light extraction layer 13 between the first electrode 14 and the substrate 10 as in the above-described embodiment, such a problem of total reflection of the light can be solved, whereby a larger amount of light can be taken out to the substrate 10 side. As a result of this, an organic EL device with improved light extraction efficiency to the outside of the device can be obtained.

Also, the convex structure 11 in the present embodiment can be formed in a comparatively easy manner by pattern forming using the photolithography method or the like. The planarizing layer 12 also can be formed by the application method or the like, thereby providing an advantage in that the organic EL device of the present embodiment facilitates a fabrication process of the device as a whole.

In the Japanese Patent No.4073510, an organic EL device is disclosed in which a condensing lens is disposed in a translucent substrate so that the convex portion of the lens will be directed towards the light extraction side. The organic EL device disclosed in the Japanese Patent No.4073510 attempts to take a larger amount of light parallel to the optical axis of the condensing lens out to the substrate by forming the condensing lens in the translucent substrate. As a result of this, it discloses that the light extraction efficiency is improved and an organic EL device providing a high brightness as viewed from the front can be obtained. However, with such a construction, though the light parallel to the optical axis of the condensing lens can be taken out, the light that is not parallel to the optical axis of the condensing lens cannot be taken out sufficiently to the substrate side because the probability that the light undergoes total reflection between the positive electrode and the substrate is high.

In contrast, according to the organic EL device of the present embodiment, by providing a convex structure 11 such as described above on the substrate 10, even the light that is not perpendicular to the substrate 10 can be taken out to the substrate 10 side by allowing it to be refracted at the convex structure 11 surface.

The substrate 10 is a translucent substrate and is formed of a substance having a high transmittance of about 80% or more on the luminescence from the luminescent layer 15. Since the substrate 10 is for supporting other members, the substrate 10 preferably has a strength of a degree that can support the layers formed thereon. Specific examples of the material of the substrate 10 include transparent or semitransparent quartz glass, transparent glass such as alkali glass and non-alkali glass, polymer film made of transparent resin such as polyethylene terephthalate, polycarbonate, polymethyl methacrylate, polypropylene, polyethylene, amorphous polyolefin, and fluororesin, and transparent ceramics. The shape, structure, size, and the like of the substrate 10 are not particularly limited and can be suitably selected in accordance with the use, purpose, and the like thereof. The thickness of the substrate 10 is not particularly limited as long as it has a sufficient strength to support the other members.

The first electrode 14 and the second electrode 16 are a pair of electrodes, of which one is a positive electrode and the other is a negative electrode. Here, description will be given by assuming that the first electrode 14 is a positive electrode and the second electrode 16 is a negative electrode; however, these may be reversed.

The positive electrode is a member for injecting positive holes efficiently into the luminescent layer and has an electric conductivity and a translucent property. Specific examples of the material of the positive electrode include materials having both an electric conductivity and a translucent property such as metal oxides such as indium tin oxide (ITO) and zinc oxide (ZnO), electrically conductive polymers such as PEDOT and polypyrrole, and carbon nanotube. A film of the positive electrode can be formed by the vacuum vapor deposition method, the sputtering method, the ion-plating method, the plating method, the spin-coating method, or the like.

The film thickness of the positive electrode is preferably about 100 nm. When the film thickness is too small, the electric conductivity decreases to raise the resistance, giving rise to a cause of decrease in luminescence efficiency. When the film thickness is too large, the positive electrode will lose flexibility, and generates cracks when a stress is applied. The positive electrode may be made of a single layer or may be made of a lamination of layers made of materials having different work functions.

The negative electrode is a member for injecting electrons efficiently into the luminescent layer and may have a reflectivity of 80% or more on the visible light. Specific examples of the material of the negative electrode include metals such as aluminum and silver. A film of the negative electrode can be formed by the vacuum vapor deposition method, the sputtering method, the ion-plating method, the plating method, the application method, or the like. When the positive electrode is formed by using a material having a high work function, the negative electrode is preferably made of a material having a low work function. The negative electrode may be made of a single layer or may be made of a lamination of layers constituted of materials having different work functions. Also, the negative electrode may be formed by using an alloy of two or more kinds of metals.

The film thickness of the negative electrode is preferably about 150 nm. When the film thickness is too small, the resistance of the device will be too large. When the film thickness is too large, it will require a long period of time to form a film of the negative electrode, raising a fear of giving damages to the adjacent layers to deteriorate the performance.

A positive hole injection layer and a positive hole transportation layer may be optionally disposed between the positive electrode and the luminescent layer. These have a function of receiving positive holes from the positive electrode and transporting the positive holes to the luminescent layer side. Also, an electron injection layer and an electron transportation layer may be optionally disposed between the negative electrode and the luminescent layer. These have a function of receiving electrons from the negative electrode and transporting the electrons to the luminescent layer side.

The luminescent layer 15 is a layer having a function of receiving positive holes from the positive electrode side and electrons from the negative electrode side and providing a place of recombination of the positive holes and electrons for luminescence. The energy given by this combination excites the host material in the luminescent layer. By transfer of the energy from the host material in an excited state to the luminescent dopant, the luminescent dopant will be in an excited state, and luminescence is obtained when the luminescent dopant returns to a ground state again.

The luminescent layer 15 has a construction such that the inside of the host material made of an organic material is doped with a luminescent metal complex (hereafter referred to as a luminescent dopant). For the host material and the luminescent dopant, materials known in the relevant field of art can be used by making a suitable selection.

A method of forming a film of the luminescent layer 15 is not particularly limited as long as it is a method that can form a thin film; however, the spin-coating method can be used, for example. After a solution containing the luminescent dopant and the host material is applied to a desired film thickness, the resultant is heated and dried on a hot plate or the like. The solution to be applied may be used after being filtered with a filter in advance.

The thickness of the luminescent layer 15 is preferably about 100 nm. The ratio of the host material and the luminescent dopant in the luminescent layer 15 is arbitrary as long as the effects of the present invention are not deteriorated.

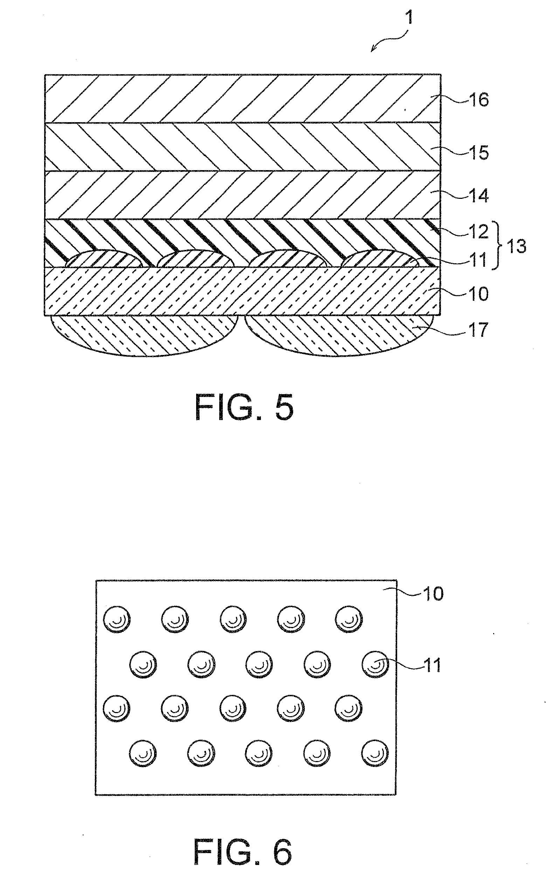

In order to extract the light more efficiently to the outside of the device, a member for extracting the light to the outside may be further provided on a surface of the substrate 10 opposite to the surface on which the convex structure 11 is disposed. As the member for taking out the light to the outside, a member known in the relevant field of art can be used; however, a microlens can be used, for example. Fig. 5 is a cross-sectional view in the case in which a microlens is used as a member for taking the light out to the outside in an organic EL device according to the first embodiment. Referring to Fig. 5, a microlens 17 preferably has a convex shape in a direction from the substrate 10 towards the outside.

### (Second embodiment)

Fig. 6 shows a plan view of a convex structure in a second embodiment.

The convex structure 11 disposed on the substrate 10 may be a plurality of lens members such as shown in Fig. 6. The lens members are disposed to be spaced apart from each other on the substrate 10 and have a convex shape in a direction opposite to the substrate 10. The cross-sectional view of the organic EL device according to the second embodiment is similar to the one in the first embodiment.

As a material of the lens members, a material similar to the convex structure described in the first embodiment can be used. Also, the description and obtained effects related to the other members are the same as those in the first embodiment.

### (Third embodiment)

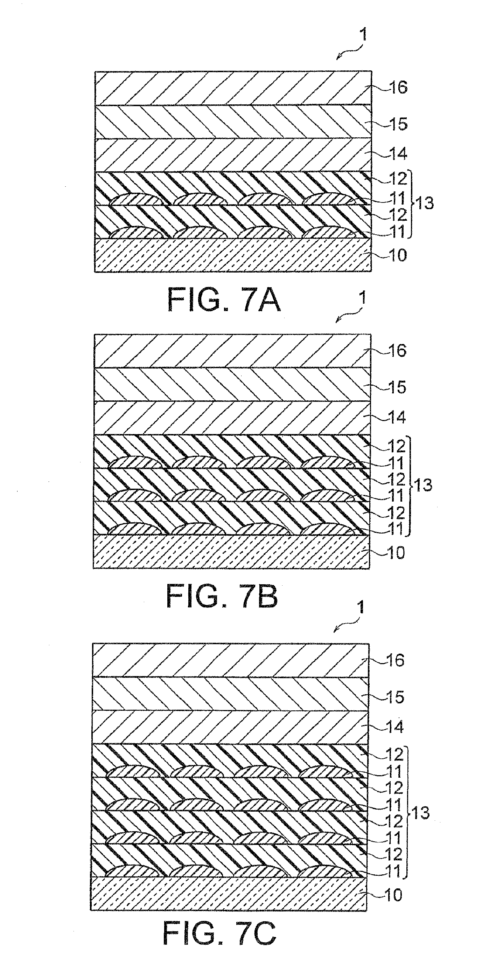

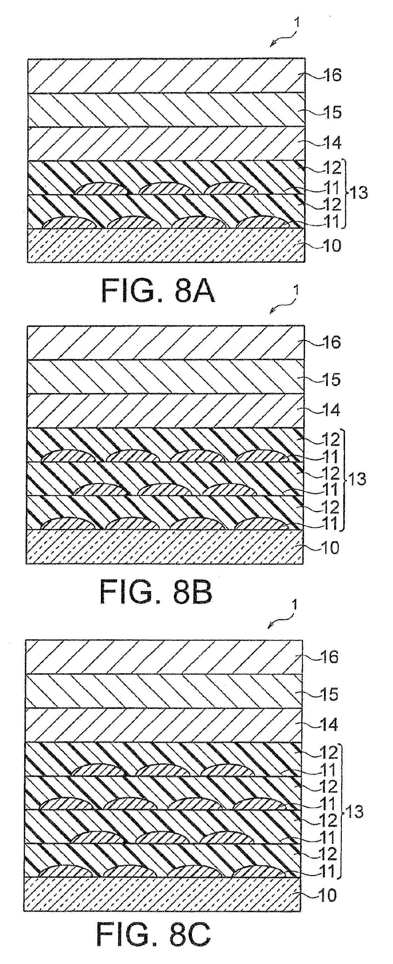

Effects similar to those in the first and second embodiments can be obtained when a plurality of light extraction layers 13 are laminated. Figs. 7A-7C are cross-sectional views illustrating an organic electroluminescent device according to the third embodiment. Figs. 8A-8C are cross-sectional views illustrating a modification of the organic electroluminescent device according to the third embodiment. Figs. 7A and 8A are cross-sectional views when two stages of light extraction layers are laminated. Figs. 7B and 8B are cross-sectional views when three stages of light extraction layers are laminated. Figs. 7C and 8C are cross-sectional views when four stages of light extraction layers are laminated. The pattern of the convex structure in the second and subsequent stages may be the same as the pattern of the convex structure 11 of the first stage as shown in Figs. 7A-7C, or may be different from the pattern of the convex structure 11 of the first stage as shown in Figs. 8A-8C. For example, as shown in Figs. 7A-7C, the position of the convex structure 11 of the first stage may be the same as the position of the convex structure 11 of the second stage. Alternatively, as shown in Figs. 8A-8C, the position of the convex structure 11 of the first stage may be shifted from the position of the convex structure 11 of the second stage.

By laminating a plurality of light extraction layers 13 in this manner, a further improvement of the efficiency of taking out the light can be expected.

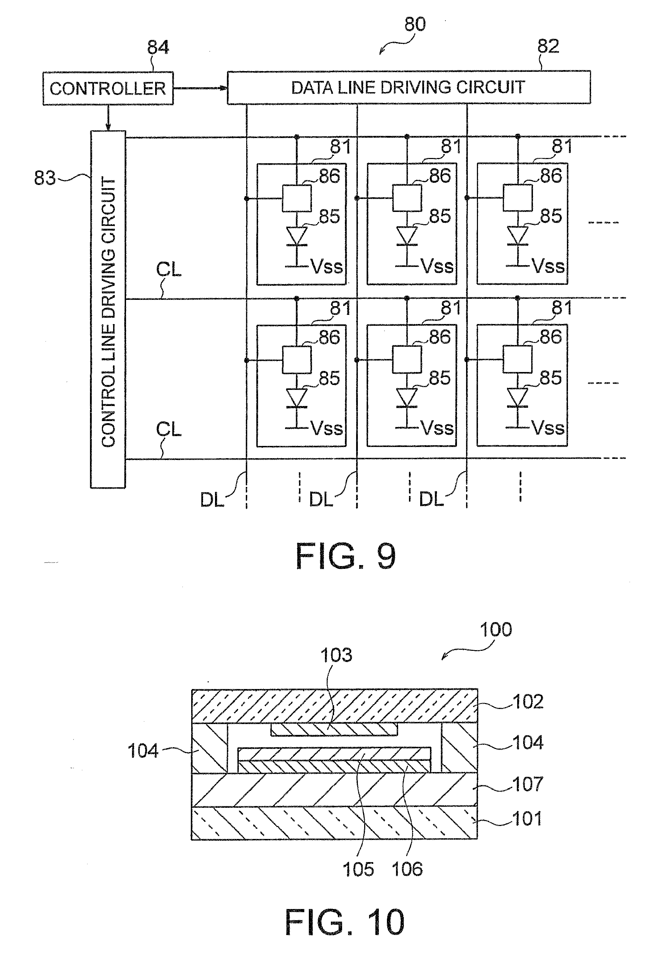

One example of the use of the organic electroluminescent device described above may be, for example, a display device or an illumination device. Fig. 9 is a circuit diagram illustrating a display device according to an embodiment.

A display device 80 shown in Fig. 9 has a construction such that pixels 81 are respectively arranged in a circuit in which control lines (CL) in the lateral direction and data lines (DL) in the longitudinal direction are disposed in a matrix form. Each of the pixels 81 includes a luminescent device 85 and a thin film transistor (TFT) 86 connected to the luminescent device 85. One terminal of the TFT 86 is connected to the control line, and the other terminal is connected to the data line. The data lines are connected to a data line driving circuit 82. Also, the control lines are connected to the control line driving circuit 83. The data line driving circuit 82 and the control line driving circuit 83 are controlled by a controller 84.

Fig. 10 is a cross-sectional view illustrating an illumination device according to an embodiment.

An illumination device 100 has a construction such that a positive electrode 107, an organic EL layer 106, and a negative electrode 105 are successively laminated on a glass substrate 101. A sealing glass 102 is disposed to cover the negative electrode 105 and is fixed with use of a UV adhesive agent 104. A desiccant 103 is placed on the surface of the sealing glass 102 on the negative electrode 105 side.

### [EXAMPLES]

### <Example 1-1>

First, as a translucent substrate, a non-alkali glass substrate having a refractive index of about 1.52 in the wavelength of 550 nm and having a transmittance of about 90% (manufactured by Asahi Glass Co., Ltd.) was prepared. Subsequently, one surface of this glass substrate was coated with a polysiloxane material (highly transparent positive-type photosensitive polysiloxane) to a film thickness of 0.6 µm by the spin-coating method, and a pattern having a square lattice shape was formed by using the photolithography method. Thereafter, the substrate on which the convex structure had been formed as shown above was fired on a hot plate for 2 minutes at a temperature of 110°C and subsequently for 5 minutes at a temperature of 230°C, so as to heat and solidify the pattern. At this time, the highly transparent positive-type photosensitive polysiloxane is thermally melted, so that the surface of the convex structure will have a rounded shape by surface tension. This convex structure has a refractive index of about 1.53 in the wavelength of 550 nm and has a transmittance of about 90%, and has a refractive index of the same degree as that of the translucent substrate.

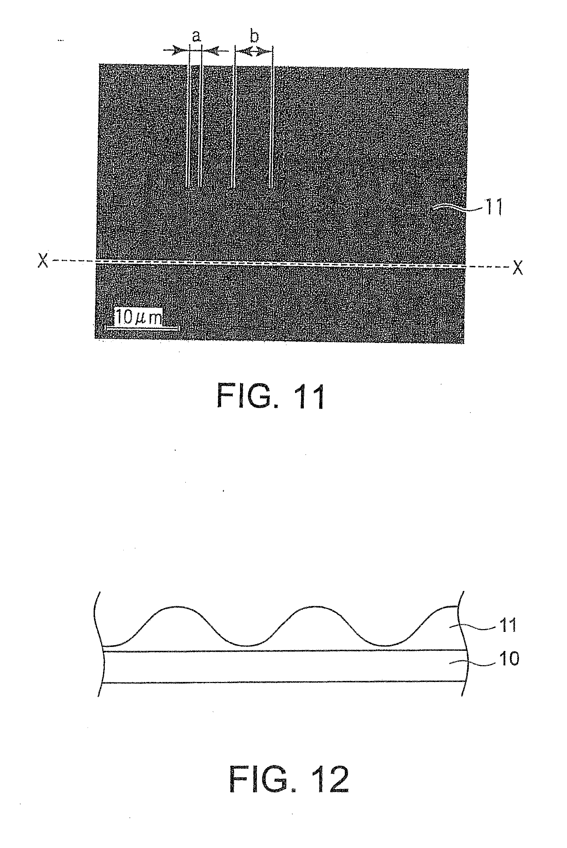

Fig. 11 is a view illustrating an SEM image of the convex structure 11 in the organic EL device according to Example 1-1, and is a plan view when the convex structure 11 is viewed from the side opposite to the substrate. In Fig. 11, the line width a is 2 µm, and the lattice interval b is 5 µm. Also, Fig. 12 is an enlarged cross-sectional view along the line X-X of the convex structure shown in Fig. 11, and shows an appearance of the convex structure 11 formed on the substrate 10.

Next, the top of the above convex structure was coated with nanofiller-containing polysiloxane to a film thickness of 2 µm by the spin-coating method, so as to cover the convex structure completely. This substrate was placed on a hot plate for heating and solidifying for 3 minutes at 180°C and subsequently for 5 minutes at 300°C so as to form a planarizing layer. This planarizing layer has a refractive index of about 1.78 in the wavelength of 550 nm and has a transmittance of about 90%, and has a refractive index of the same degree as that of the positive electrode. Hereafter, the layer including the convex structure and the planarizing layer is referred to as a light extraction layer.

Subsequently, an ITO film having a film thickness of 100 nm was formed on the above planarizing layer at room temperature by the sputtering method, so as to form a positive electrode. Thereafter, UV ozone cleaning of 10 minutes was carried out and the resultant was fired at 230°C for one hour in a nitrogen atmosphere, followed by an Ar plasma treatment. On the positive electrode, a luminescent layer and an Al negative electrode having a thickness of 100 nm were successively formed by the vacuum vapor deposition method, so as to fabricate an organic electroluminescent device.

### <Example 1-2>

An organic EL device was fabricated in the same manner as in Example 1-1 except that a microlens for extracting the light to the outside was provided on the surface of the substrate opposite to the surface on which the convex structure had been formed. As the microlens, a microlens having a refractive index of about 1.5 in the wavelength of 550 nm (manufactured by Optmate Corporation) was used and placed so that the convex surface thereof would face in the direction opposite to the substrate. As the microlens, a microlens having a refractive index of about 1.5 (manufactured by Optmate Corporation) was placed on the translucent substrate having a refractive index of 1.5 via a refractive index matching liquid having a refractive index of the same degree as that of the translucent substrate (the liquid manufactured by Cargill Laboratory; having a refractive index of about 1.5).

### <Example 2-1>

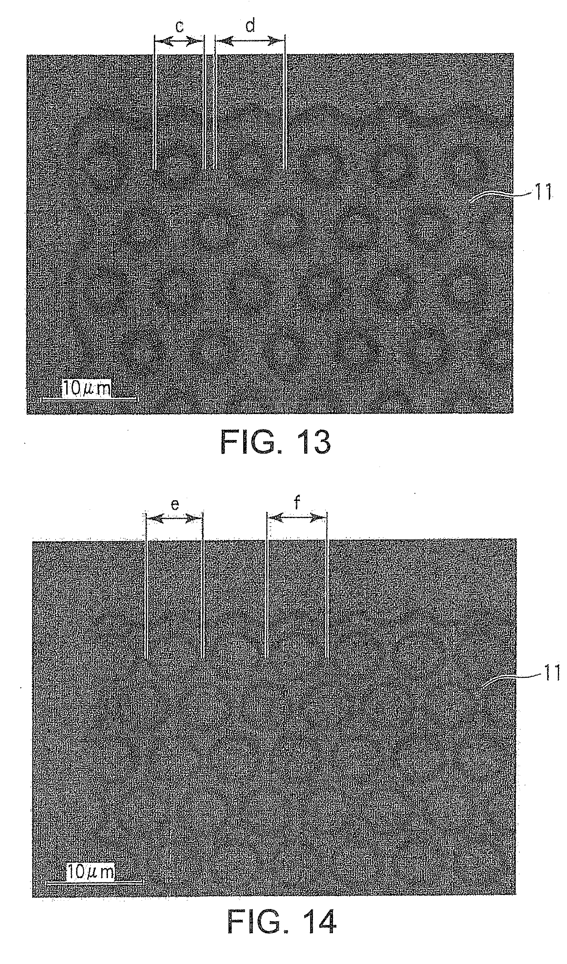

An organic EL device was fabricated in the same manner as in Example 1-1 except that the convex structure 11 was formed to have a triangular lattice shape such as shown in Fig. 13. Fig. 13 is a view illustrating an SEM image of the convex structure 11 in the organic EL device according to Example 2-1, and is a plan view when the convex structure 11 is viewed from the side opposite to the substrate. In Fig. 13, the diameter c of the concave portion is 3 µm, and the lattice interval d is 5 µm.

### <Example 2-2>

An organic EL device was fabricated in the same manner as in Example 1-2 except that the convex structure 11 was formed to have a triangular lattice shape such as shown in Fig. 13.

### <Example 3-1>

An organic EL device was fabricated in the same manner as in Example 1-1 except that the convex structure 11 was formed to have a triangular lattice shape such as shown in Fig. 14. Fig. 14 is a view illustrating an SEM image of the convex structure 11 in the organic EL device according to Example 3-1, and is a plan view when the convex structure 11 is viewed from the side opposite to the substrate. In Fig. 14, the diameter e of the concave portion is 5 µm, and the lattice interval f is 6 µm.

### <Example 3-2>

An organic EL device was fabricated in the same manner as in Example 1-2 except that the convex structure 11 was formed to have a triangular lattice shape such as shown in Fig. 14.

### <Example 4-1>

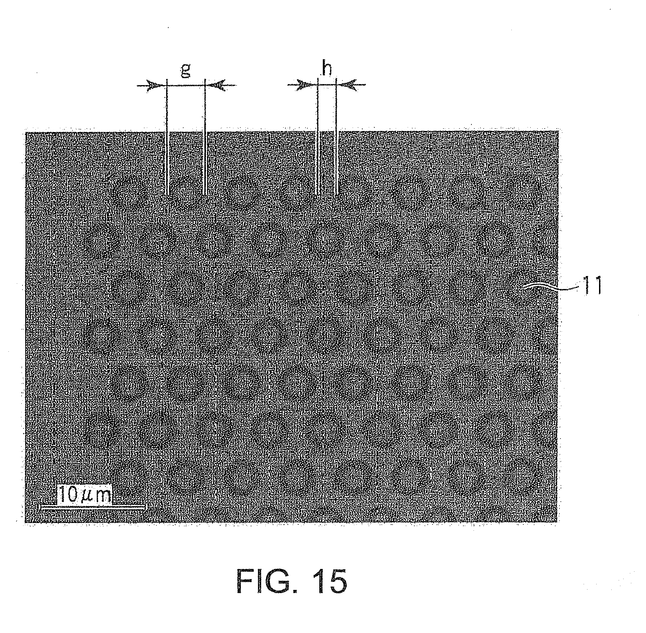

An organic EL device was fabricated in the same manner as in Example 1-1 except that a lens member was disposed in a triangular lattice shape as the convex structure 11 as shown in Fig. 15. Fig. 15 is a view illustrating an SEM image of the convex structure 11 in the organic EL device according to Example 4-1, and is a plan view when the convex structure 11 is viewed from the side opposite to the substrate. In Fig. 15, the diameter g of the lens member is 3 µm, and the interval between the lenses is 2 µm.

### <Example 4-2>

An organic EL device was fabricated in the same manner as in Example 1-2 except that a lens member was disposed in a triangular lattice shape as the convex structure 11 as shown in Fig. 15.

### <Comparative Example 1>

An organic EL device was fabricated in the same manner as in Example 1-1 except that the convex structure and the planarizing layer were not provided.

### <Comparative Example 2>

An organic EL device was fabricated in the same manner as in Example 1-2 except that the convex structure and the planarizing layer were not provided.

### <Test Example 1: comparison of light extraction efficiency>

With respect to the organic EL devices fabricated in Example 1-1, Example 1-2, and Comparative Example 1, the light extraction efficiency was estimated by optical calculation. The results thereof are shown in the following Table 1. In Table 1, the light extraction efficiency refers to the ratio of the light that can be extracted to the outside of the device among the luminescence generated in the luminescent layer. Also, the enhancement factor means the ratio when the light extraction efficiency of Comparative Example 1 is assumed to be 1.

**[TABLE 1]**

| | Light extraction efficiency (%) | Enhancement factor |
|---|---|---|
| Comparative Example 1 | 16.35 | 1 |
| Example 1-1 | 22.57 | 1.38 |
| Example 1-2 | 43.16 | 2.64 |

From Table 1, it will be understood that the light extraction efficiency is improved by providing a light extraction layer.

### <Test Example 2: measurement of external quantum efficiency>

With respect to the organic EL devices fabricated in the above Examples and Comparative Examples, the external quantum efficiency was measured. The measurement was carried out by using an external quantum efficiency measuring apparatus (manufactured by Hamamatsu Photonics K.K.).

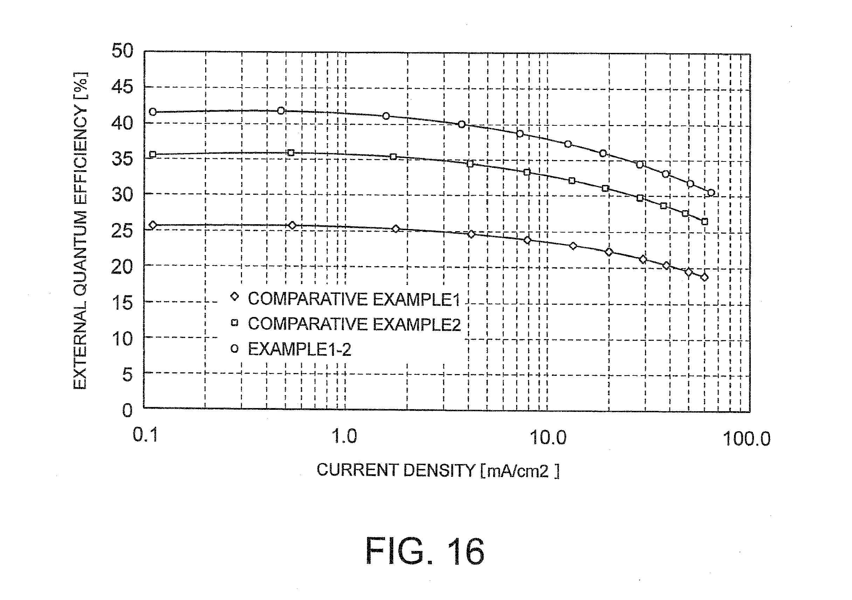

With respect to the organic EL devices fabricated in Example 1-2, Comparative Example 1, and Comparative Example 2, a result of measuring the external quantum efficiency is shown in Fig. 16. When the external quantum efficiency is compared at a current density of 1 mA/cm², the organic EL device of Comparative Example 1 had an efficiency of about 25%; the organic EL device of Comparative Example 2 had an efficiency of about 35%; and the organic EL device of Example 1-2 had an efficiency of about 40%. From this result, it will be understood that the external quantum efficiency of the device is considerably improved by providing a light extraction layer.

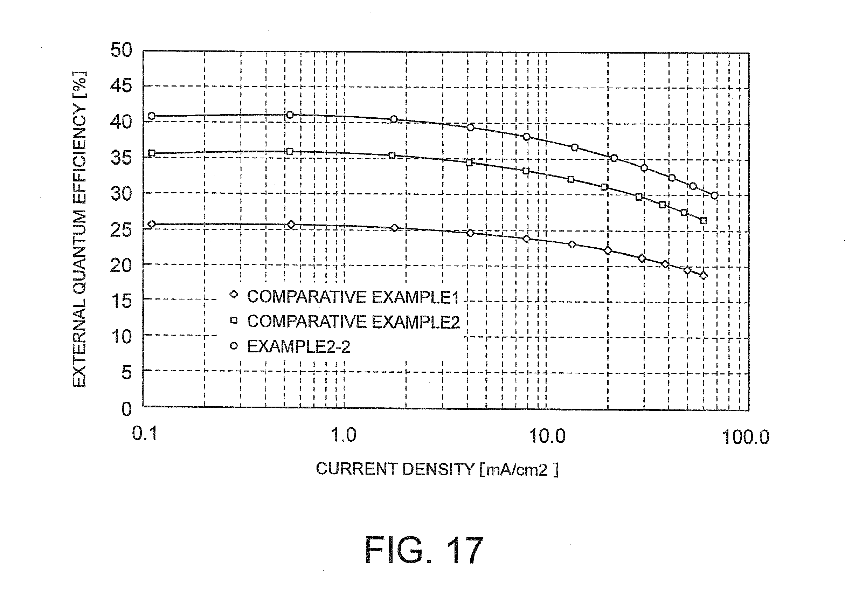

With respect to the organic EL devices fabricated in Example 2-2, Comparative Example 1, and Comparative Example 2, a result of measuring the external quantum efficiency is shown in Fig. 17.

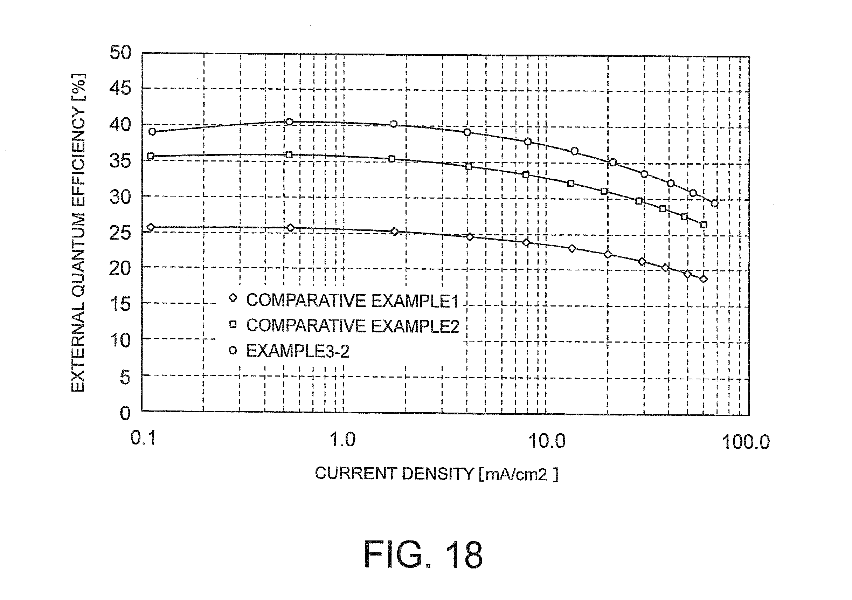

With respect to the organic EL devices fabricated in Example 3-2, Comparative Example 1, and Comparative Example 2, a result of measuring the external quantum efficiency is shown in Fig. 18.

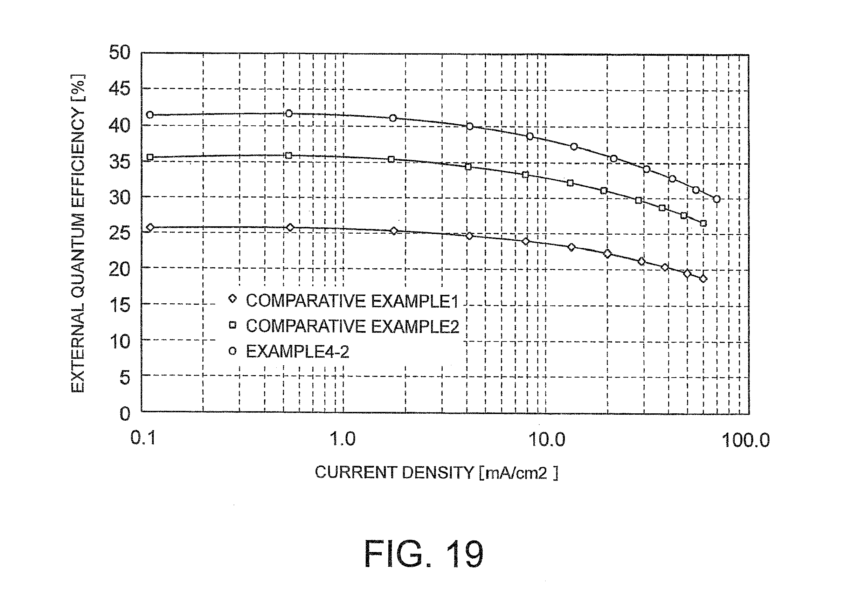

With respect to the organic EL devices fabricated in Example 4-2, Comparative Example 1, and Comparative Example 2, a result of measuring the external quantum efficiency is shown in Fig. 19.

From the results of Figs. 17, 18, and 19 also, it will be understood that the external quantum efficiency of the device is considerably improved by providing a light extraction layer. The improvement of the external quantum efficiency such as shown above seems to derive from the fact that the light extraction efficiency of the device is improved by providing the light extraction layer.

### <Test Example 3: Simulation of light extraction efficiency when a plurality of light extraction layers are laminated>

An organic EL device was fabricated in the same manner as in Example 1-2 except that a plurality of light extraction layers were laminated. Specifically, as already shown in Fig. 7, an organic EL device in which two layers, three layers, or four layers of light extraction layers were laminated were fabricated, and a microlens was placed on the outside of the substrate in the same manner as in Example 1-2. The light extraction layers of the second and subsequent layers were laminated by further forming a convex structure and a planarizing layer on the planarizing layer lying thereunder. The method of forming the convex structure and the planarizing layer is as shown in Example 1-1.

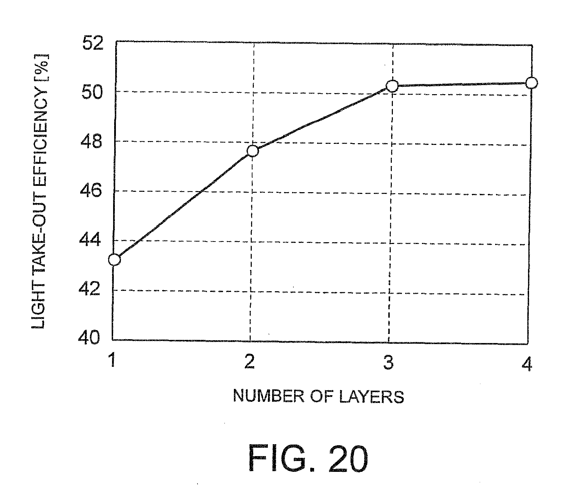

With respect to the organic EL devices fabricated as shown above, the light extraction efficiency was simulated. The results thereof are shown in Fig. 20. Here, the light extraction efficiency in Fig. 20 refers to the ratio of the light that can be extracted to the outside of the device among the light generated in the luminescent layer. From Fig. 20, it will be understood that a higher light extraction efficiency can be obtained when two or more light extraction layers are laminated as compared with a case in which only one light extraction layer is provided.

According to the above-described embodiments or Examples, the light extraction efficiency is improved and, as a result thereof, an organic electroluminescent device with improved luminescence efficiency as well as a display device and an illumination device using the same can be provided.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. An organic electroluminescent device comprising:
a translucent substrate;
a light extraction layer including a convex structure disposed in a net form on one surface of the substrate and having a tilted surface forming an acute angle relative to the substrate, and a planarizing layer disposed on the convex structure;
a first electrode disposed on the light extraction layer;
a luminescent layer disposed on the first electrode and containing a host material and a luminescent dopant; and
a second electrode disposed on the luminescent layer,
wherein
a refractive index of the planarizing layer is approximately equal to a refractive index of the first electrode or is larger than the refractive index of the first electrode, and
a refractive index of the convex structure is smaller than the refractive index of the planarizing layer.

2. The organic electroluminescent device according to claim 1, wherein the refractive index of the convex structure is approximately equal to a refractive index of the substrate or is smaller than the refractive index of the substrate.

3. The organic electroluminescent device according to claim 1, wherein the convex structure is disposed in a lattice form on the substrate.

4. The organic electroluminescent device according to claim 1, wherein the convex structure is formed in such a manner that a bottom surface thereof is in contact with the substrate, and a surface thereof that is in contact with the planarizing layer has an arch shape.

5. The organic electroluminescent device according to claim 1, wherein a plurality of the light extraction layers are laminated.

6. An organic electroluminescent device comprising:
a translucent substrate;
a light extraction layer including a plurality of lens members disposed to be spaced apart from each other on one surface of the substrate and having a convex shape in a direction opposite to the substrate, and a planarizing layer disposed on the lens members;
a first electrode disposed on the light extraction layer;
a luminescent layer disposed on the first electrode and containing a host material and a luminescent dopant; and
a second electrode disposed on the luminescent layer,
wherein
a refractive index of the planarizing layer is approximately equal to a refractive index of the first electrode or is larger than the refractive index of the first electrode, and
a refractive index of the convex structure is smaller than the refractive index of the planarizing layer.

7. The organic electroluminescent device according to claim 6, wherein a refractive index of the lens members is approximately equal to a refractive index of the substrate or is larger than the refractive index of the substrate.

8. The organic electroluminescent device according to claim 6, wherein a plurality of the light extraction layers are laminated.

9. A display device including the organic electroluminescent device according to claim 1.

10. An illumination device including the organic electroluminescent device according to claim 1.
